# EUROPEAN PATENT APPLICATION

(11) **EP 4 517 355 A1**
(43) Date of publication of application: **05.03.2025**
(21) Application number: 23195016.3
(22) Date of filing: 04.09.2023
(51) Int. Cl.: G01R 33/28, G01R 33/3815, G01R 33/54

(54) **MAGNETIC RESONANCE IMAGING MAGNET WITH SCHEDULED POWER CONTROL**

(71) Applicant: Koninklijke Philips N.V., 5656 AG Eindhoven (NL)
(72) Inventor: FORTHMANN, Peter, Eindhoven (NL); VERNICKEL, Peter, Eindhoven (NL); LIPS, Oliver, 5656 AG Eindhoven (NL)
(74) Representative: Philips Intellectual Property & Standards

(57) **Abstract**

Disclosed herein is a medical system (100, 300) comprising a magnetic resonance imaging magnet (102) with superconducting windings (110) and a magnet power supply (112) configured to operate the magnetic resonance imaging magnet in a driven mode. The execution of machine executable instructions (140) causes a computational system (132) to repeatedly: receive (200) scheduling data descriptive (142) of planned usage of a magnetic resonance imaging system (302); determine (202) in-use periods and idle periods for the magnetic resonance imaging system using the scheduling data; control (204) the magnet power supply to ramp down electrical power to magnetic resonance imaging magnet to place the magnetic resonance imaging magnet in a power saving mode during the idle periods; and control (206) the magnet power supply to continuously supply the electrical power to the magnetic resonance imaging magnet to operate the magnetic resonance imaging magnet in the drive mode during the in-use periods.

## Description

### FIELD OF THE INVENTION

The invention relates to magnetic resonance imaging, in particular to magnetic resonance imaging magnets operated in a driven mode.

### BACKGROUND OF THE INENTION

A large static magnetic field (Bo field or main magnetic field) is used by Magnetic Resonance Imaging (MRI) scanners to align the nuclear spins of atoms as part of the procedure for producing images within the body of a patient. Traditionally MRI scanners have used superconducting coils that have their current ramped up with a power supply and then the power supply is removed. These magnets are operated in the so-called persistent mode. Although additional electrical current is not needed, such magnetic resonance imaging magnets use a cryostat to keep the superconducting windings, and this may be costly.

Some newer magnetic resonance imaging magnets use superconducting coils from high temperature superconductors or other materials such as MgB2 which have less stringent cooling requirements. Such magnets may be operated in a so-called driven mode, where amounts of current are continuously supplied to the superconducting coils to maintain the main magnetic field. Overall, these newer magnetic designs have shown to have the potential to reduce the overall operating cost for a magnetic resonance imaging system.

The journal article Takeda, Y., et al. "Review of the temporal stability of the magnetic field for ultra-high field superconducting magnets with a particular focus on superconducting joints between HTS conductors." Superconductor Science and Technology 35.4 (2022): 043002 discloses that superconducting magnets used in applications such as magnetic resonance imaging (MRI) and nuclear magnetic resonance (NMR) require significant temporal magnetic field stability, which can be achieved when the MRI and NMR magnets are operated in the persistent current mode (persistent-mode) using superconducting joints. However, the ultra-high field MRI and NMR magnets are sometimes operated in the driven mode. Herein, we present an analysis of the temporal magnetic field drift and fluctuations observed for MRI and NMR magnets operating in the driven mode and an exploration of effective methods for stabilizing the temporal magnetic field fluctuations. In the last decade, substantial improvements have been achieved in superconducting joints between high-temperature superconductors (HTSs). These superconducting joints enable the development of persistent-mode ultra-high field magnets using HTS coils. The article reviews the superconducting joint technology for HTS conductors and describes the results of the persistent-mode operation achieved by a medium-field NMR magnet using an HTS coil. Particularly, the cutting-edge progress achieved concerning HTS superconducting joints, including joining methods, superconducting properties, and future prospects, is highlighted.

### SUMMARY OF THE INVENTION

The invention provides for a medical system, a computer program, and a method in the independent claims. Embodiments are given in the dependent claims.

In one aspect the invention provides for a medical system that comprises a magnetic resonance imaging magnet for a magnetic resonance imaging system. The magnetic resonance imaging magnet comprises superconducting windings. The medical system further comprises a magnet power supply that is configured to provide electrical power to the superconducting windings. The magnet power supply is configured to operate the magnetic resonance imaging magnet is a driven mode.

The medical system further comprises a memory storing machine-executable instructions. The medical system further comprises a computational system. Execution of the machine-executable instructions causes the computational system to repeatedly receive scheduling data descriptive of planned usage of the magnetic resonance imaging system. Execution of the machine-executable instructions further causes the computational system to repeatedly determine in-use periods and idle periods for the magnetic resonance imaging system using the scheduling data. Execution of the machine-executable instructions further causes the computational system to repeatedly control the magnet power supply to ramp down electrical power to the magnetic resonance imaging magnet to place the magnetic resonance imaging magnet in a power saving mode during idle periods. Execution of the machine-executable instructions further causes the computational system to repeatedly control the magnet power supply to continuously supply the electrical power to the magnetic resonance imaging magnet to operate the magnetic resonance imaging magnet in the driven mode during the in-use periods.

This embodiment may be beneficial because it may greatly reduce the amount of electrical energy to operate the magnetic resonance imaging magnet in the driven mode. Also, by schedule when to ramp down and ramp up the electrical power to the magnetic resonance imaging magnet, it is ensured that the magnetic resonance imaging magnet is available when needed while at the same time reducing the power consumption. With high-temperature superconducting (HTS) technology, it is possible to save on refrigeration power if an MRI cryostat is operated at 20 K rather than 4 K like the conventional systems. Reliable and economic persistent joint fabrication, necessary for persistent magnet operation, is very difficult, which leaves driven mode magnet operation as a practical alternative. In that case, a magnet power supply may be permanently connected to the magnet and supplies a constant current.

In another aspect the invention provides for a method of operating a medical system. The medical system comprises a magnetic resonance imaging magnet for a magnetic resonance imaging system. The magnetic resonance imaging magnet comprises superconducting windings. The medical system further comprises a magnet power supply that is configured to provide electrical power (electrical current) to the superconducting windings. The magnet power supply is configured to operate the magnetic resonance imaging magnet in a driven mode.

The method comprises repeatedly receiving scheduling data that is descriptive of planned usage of the magnetic resonance imaging system. The method further comprises repeatedly determining in-use periods and idle periods for the magnetic resonance imaging system using the scheduling data. The method further comprises repeatedly controlling the magnet power supply to ramp down electrical power to the magnetic resonance imaging magnet to place the magnetic resonance imaging magnet in a power saving mode during the idle periods. The method further comprises repeatedly controlling the magnet power supply to continuously supply the electrical power to the magnetic resonance imaging magnet to operate the magnetic resonance imaging magnet in driven mode during the in-use periods.

In another aspect the invention provides for a computer program comprising machine-executable instructions for execution by a computational system configured for controlling a medical system. The medical system comprises a magnetic resonance imaging magnet for a magnetic resonance imaging system. The magnetic resonance imaging magnet comprises superconducting windings. The medical system further comprises a magnet power supply that is configured to provide electrical power to the superconducting windings. The magnet power supply is configured to operate the magnetic resonance imaging magnet in a driven mode.

Execution of the machine-executable instructions causes the computational system to repeatedly receive scheduling data that is descriptive of planned usage of the magnetic resonance imaging system. Execution of the machine-executable instructions further causes the computational system to repeatedly determine in-use periods and idle periods for the magnetic resonance imaging system using the scheduling data. Execution of the machine-executable instructions further causes the computational system to repeatedly control the magnet power supply to ramp down electrical power to the magnetic resonance imaging magnet to place the magnetic resonance imaging magnet in a power saving mode during the idle periods. Execution of the machine-executable instructions further causes the computational system to repeatedly control the magnet power supply to continuously supply the electrical power to the magnetic resonance imaging magnet to operate the magnetic resonance imaging magnet in the driven mode during the in-use periods.

### BRIEF DESCRIPTION OF THE DRAWINGS

In the following preferred embodiments of the invention will be described, by way of example only, and with reference to the drawings in which:
Fig. 1 illustrates an example of a medical system.
Fig. 2 shows a flow chart which illustrates a method of using the medical system of Fig. 1.
Fig. 3 illustrates a further example of a medical system.
Fig. 4 shows a flow chart which illustrates a method of using the medical system of Fig. 3.

### DETAILED DESCRIPTION OF EMBODIMENTS

Like numbered elements in these figures are either equivalent elements or perform the same function. Elements which have been discussed previously will not necessarily be discussed in later figures if the function is equivalent.

In a driven mode electrical power is supplied to the magnetic resonance imaging magnet continually.
In some examples the superconducting windings could be high-temperature superconducting windings.

In another example the magnet power supply comprises a battery. The magnet power supply is configured to store electric power from the magnetic resonance imaging magnet in the battery during ramp down. In some examples the power that is then stored in the battery may then be used to ramp up the electrical power to the magnetic resonance imaging magnet to operate the magnetic resonance imaging magnet in the driven mode. The electrical power that is stored in the magnet from ramp down may also be used to maintain the continuous supply of electrical power to the magnet in the in-use period also. The advantage of storing the electrical power in the battery is that the power is then not wasted and may reduce the electrical power consumption of the medical system.

In another example the magnet power supply is configured to supply electrical power to the magnetic resonance imaging magnet at least partially using the battery. This may be advantageous because it may provide for a means of using the power consumption of maintaining the magnet in the driven mode.

In another example the medical system further comprises an emergency power system. The emergency power system comprises the battery. The emergency power system may for example be useful in powering or supplying electrical power to a medical facility in case of an emergency situation. For example, if there is an emergency situation where there is a critical loss of power, the magnetic resonance imaging magnet could have its power dumped into the battery, which would then be used to power other critical components or services in a medical facility or hospital.

In another example execution of the machine-executable instructions further causes the computational system to receive a facility alert from the emergency power system. Execution of the machine-executable instructions further causes the computational system to control the magnet power supply to ramp down electrical power to the magnetic resonance imaging magnet to supply electrical power to the battery in response to the facility alert. In this example, the facility alert causes the transfer of power from the magnetic resonance imaging magnet to the battery. This enables the magnetic resonance imaging magnet to automatically supply power in an emergency situation.

In another example the medical system further comprises a magnetic resonance imaging system. The magnetic resonance imaging system comprises the magnetic resonance imaging magnet. The memory further stores pulse sequence commands. Execution of the machine-executable instructions causes the computational system to acquire k-space data using the magnetic resonance imaging magnet by controlling the magnetic resonance imaging system with the pulse sequence commands when the magnetic resonance imaging magnet is being operated in the driven mode. This example may be beneficial because overall the magnet in the driven mode may require fewer maintenance steps such as providing cryogenic liquids and other costly maintenance. The use of the scheduling system may provide for the cost effective use of the magnetic resonance imaging system.

In another example execution of the machine-executable instructions further causes the computational system to reconstruct a magnetic resonance image from the k-space data.

In another example execution of the machine-executable instructions further causes the computational system to control the magnet power supply to ramp down electrical power to the magnetic resonance imaging magnet to place the magnetic resonance imaging magnet in the power saving mode after acquisition of the k-space data is complete. This example may be beneficial because it may cause the magnetic resonance imaging magnet to power down automatically and thereby save power automatically.

In another example, the magnetic resonance imaging magnet comprises a magnetic field sensor that is configured for measuring a magnetic field strength. Execution of the machine-executable instructions further causes the computational system to repeatedly receive the magnetic field strength from the magnetic field sensor. Execution of the machine-executable instructions further causes the computational system to repeatedly control the magnet power supply to adjust electrical power supplied to the magnetic resonance imaging magnet such that the magnetic field strength is within a predetermined range of value. This example may be beneficial for several reasons. The measurement of the magnetic field strength may provide confidence that the magnetic resonance imaging magnet is functioning properly. The use of the magnetic field strength has a feedback control for the magnet power supply may enable the magnetic resonance imaging magnet to be ramped up to a useable state more rapidly. This would then facilitate the saving of electrical power in operating the magnetic resonance imaging magnet. The particular magnetic field of a magnetic resonance imaging system could be constant even outside of the imaging zone or the region where magnetic resonance imaging takes place. For example, the magnetic field sensor may be placed within the bore of a magnet, however, not in the region which is normally used for imaging. This may enable easy integration of the magnetic field sensor into the magnetic resonance imaging system.

The magnetic field sensor may be implemented in different ways. For example a fiber optic based magnetic field sensor or a field sensor which uses an NMR measurement may be used. In another example the step of receiving the scheduling data comprises receiving fixed operating times for the magnetic resonance imaging magnet. This for example could be normal times when the magnetic resonance imaging system is scheduled to be available.

In another example, the step of receiving the scheduling data comprises receiving appointments for magnetic resonance imaging examinations using the magnetic resonance imaging system. Scheduling the powering up and down of the magnetic resonance imaging magnet around the appointments may for example provide for a greater savings in electrical power if the magnetic resonance imaging system is being used infrequently.

In another example the medical system comprises a manual power supply control that is configured to manually override control of the magnet power supply to ramp down electrical power to the magnetic resonance imaging magnet or to continuously supply the electrical power to the magnetic resonance imaging magnet to operate the magnetic resonance imaging magnet in the driven mode. The manual power supply control may be used to either ramp up or ramp down the electrical power to the magnetic resonance imaging magnet manually. This may be useful in situations where the magnet has already been ramped down and it is desired to use the magnetic resonance imaging system when an examination has not been scheduled. In some cases, when there is an emergency, the manual power supply control may be used to ramp down the electrical power of the magnetic resonance imaging magnet and put it in a safe mode where the magnetic field has been either greatly reduced or eliminated.

In another example during the idle period the electrical power in the magnetic resonance imaging magnet is reduced to zero. This may be beneficial as it may provide for greater savings in electrical power. This may also facilitate the cleaning of the room in which the magnetic resonance imaging magnet is located or during routine maintenance. The magnetic fields from magnetic resonance imaging magnets may be hazardous. Reducing the electrical power to zero during the idle periods may also increase the safety of the magnetic resonance imaging magnet.

In another example, during the idle period the electrical power supplied to the magnetic resonance imaging magnet is reduced by between 80% and 50% compared to when the magnetic resonance imaging magnet is in the driven mode. By only reducing the power, it may provide for a means of ramping up the electrical power and putting the magnetic resonance imaging magnet in an operating mode more rapidly.

In another example the superconducting windings are formed from MgB2 (Magnesium diboride).

In another example the superconducting windings are formed from YBCO (Yttrium Barium Copper oxide).

In another example the superconducting windings are formed from ReBCO (rare-earth Barium Copper oxide).

In another example the superconducting windings are formed from BSCCO (Bismuth Strontium Calcium Copper oxide).

In another example the superconducting windings are formed from BSCCO2212 (Bi₂Sr₂CaCu₂O₈₊ₓ).

In another example the magnet power supply is permanently connected to the superconducting windings. In conventional magnetic resonance imaging systems the power supply is only connected during the ramp up of the magnetic resonance imaging magnet. The connections to the power supply are then removed to reduce the heat transfer to the superconducting windings. When a magnet is operated in the so-called driven mode, then the power supply must be attached continuously in order to supply the electrical power.

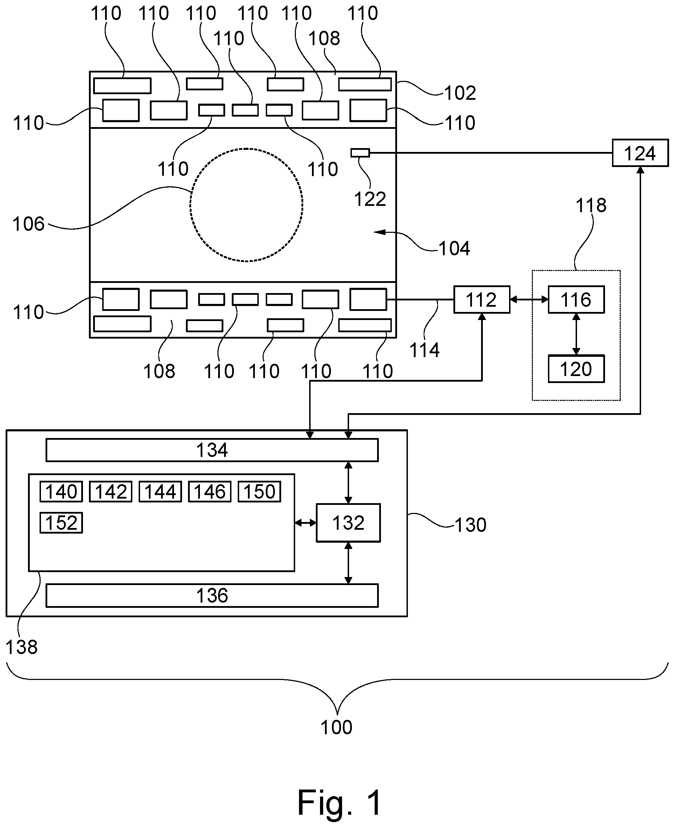

Fig. 1 illustrates an example of a medical system 100. The medical system is shown as comprising a magnetic resonance imaging magnet 102. The magnetic resonance imaging magnet 102 in this example is a cylindrical magnet with a bore 104 through it. Although a cylindrical magnet is illustrated, other types of magnets such as an open magnet may also be used. When energized the magnetic resonance imaging magnet 102 creates a B0 or main magnetic field with an imaging zone 106. The imaging zone 106 is a region of magnetic field strength and homogeneity sufficient to image objects within the imaging zone 106. The magnet 102 has a cryostat 108 that contains superconducting windings 110. There is a magnet power supply 112 with a permanent connection 114 to supply electrical power to the superconducting windings 110. The magnetic power supply 112 is configured to operate in a so-called driven mode, where when during operation the superconducting windings 110 are continually supplied with power by the magnet power supply 112.

The magnet power supply 112 is configured to ramp up or ramp down the electrical power to the superconducting windings 110. The medical system 100 is shown as comprising an optional battery 116 that can be used to store electrical power that is received from the superconducting windings 110 when they are powered down. The medical system 100 is also shown as comprising an optional emergency power supply 118. The optional emergency power supply 118 shares the battery 116 with the medical system 100. The optional emergency power supply 118 may also comprise an emergency power supply controller 120. The emergency power supply controller 120 may, in some instances, be able to signal the magnet power supply 112 to power down the magnet 102 and deposit energy into the battery 116.

The medical system 100 is further shown as comprising a computer 130. The computer 130 is shown as comprising a computational system 132 that is in communication with a hardware interface 134, an optional manual power supply control 136, and a memory 138. The hardware interface 134 enables the computational system 132 to communicate with and/or control other components of the medical system 100.

The optional manual power supply control 136 may for example be a user interface or it may be a manual switch or controller, which enables an operator to remotely control the magnet power supply 112 to either ramp up or ramp down power supplied to the superconducting windings 110. This may be useful in a variety of situations. If the magnet 102 is currently powered down the manual power supply control 136 may be used to put the medical system 100 into an operational or in-use state. If there is an emergency and there is a need to shut off the power to the superconducting windings 110, the manual power supply control 136 can be used to have the magnet power supply 112 withdraw power from the superconducting windings 110. This may be very useful in emergency situations where it is desired to shut off the main magnetic field.

The memory 138 is intended to represent various types of memory which are accessible to the computational system 132. The memory 138 is shown as containing machine-executable instructions 140. The machine-executable instructions 140 enable the computational system 132 to perform various control and computational tasks. The memory 138 is further shown as containing scheduling data 142 that has been received. It may for example have been entered using a user interface or may have been received via a network connection. The memory 138 is further shown as containing determined in-use periods 144 and determined idle periods 146 that have been determined from the scheduling data 142. The in-use periods 144 and the idle periods 146 may be used to determine when to switch on and off electrical power to the superconducting windings 110.

The memory is further shown as containing an optional measured magnetic field strength 150 that has been measured with the magnetic field sensor 122. This can be compared to a predetermined range of value 152. For example, if the measured magnetic field strength is too low or below the predetermined range of value 152, this can be used as a control loop to increase the electrical power to the superconducting windings 110. Likewise, if the measured magnetic field strength 150 is too strong or too large and is outside or above the predetermined range of value 152, then the electrical power can be decreased to the superconducting windings 110. This may be particularly useful in stabilizing the magnetic field in the imaging zone 106 rapidly when the electrical power to the superconducting windings 110 is switched on and off between the in-use periods and the idle periods.

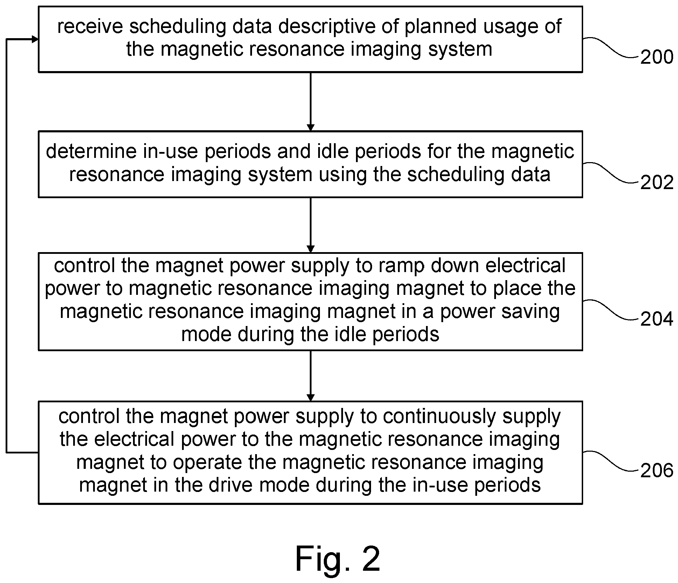

Fig. 2 shows a flowchart which illustrates a method of operating the medical system 100 illustrated in Fig. 1. In step 200 the scheduling data 142 is received. The scheduling data is descriptive of the planned usage of the magnetic resonance imaging system. In step 202, the in-use periods 144 are determined using the scheduling data 142. In step 202, the idle periods 146 are also determined using the scheduling data 142. In step 204, the magnet power supply 112 is controlled to ramp down electrical power to the magnetic resonance imaging magnet 102 to place the magnetic resonance imaging magnet in a power saving mode during the idle periods 146. Decreasing electrical power to the magnetic resonance imaging magnet is decreasing electrical power to the superconducting windings 110. In step 206, the magnet power supply 112 is controlled to continuously supply the electrical power to the magnetic resonance imaging magnet 102 to operate the magnetic resonance imaging magnet in the drive mode during the in-use periods 144. Supplying electrical power to the magnetic resonance imaging magnet 102 means supplying electrical power to the superconducting windings 110. Steps 200, 202, 204, and 206 may be performed in a loop continuously and in varying order.

Although the energization chain in a driven mode magnetic resonance imaging magnet involves small resistances, there is still some power loss involved. The lead and connection resistances will add up to a few milli ohms, and the power supply itself will have AC/DC conversion losses. When the MRI is not in use, these can be considered unnecessary standby losses. They would be on the order of 500 W for currents on the order of 250 A.

Turning off the magnet power supply during planned intervals as is illustrated in Fig. 2 when the scanner is not in use, for example at night may reduce these power losses. The idea is to save power over night, for example. For that reason, one would turn off the magnet power supply. An MgB2-based magnet can be ramped up and down within minutes, so theoretically, one could ramp it down at the end of the day and ramp it up again in the morning, thus saving a few 100 Wh/h during the night. As an additional benefit, service and cleaning activities, for example, can be carried out during the time when the magnet is switched off without any restrictions or harm due to the magnetic field.

One would, however, lose the energy stored in the magnetic field of the magnet. For a 1.5 T magnet, this would be on the order of 1 kWh. This mitigation scheme is therefore suited for off-times of greater than 3 hours. An additional idea to mitigate that loss, i.e. to also save the stored energy, is to use a battery 116 that can sustain the charge current coming out of the down-ramping magnet. In that case, the energy would just get transferred to the batteries and can later be reused. The battery does not have to be a standalone one for this purpose. The cost for this would not be justified. If it could be combined with an uninterruptible power source or emergency power system 118, for example, that would be a perfect synergy.

A complementary smart planning systems analysis the scheduled and potentially expected activities for the system and provides optimized times for ramping the system down and up again. For this purpose several data sources (scheduling of patients, new admissions to emergency room (potentially in need of imaging), monitoring/logging data of the MR system) can be analyzed. Additionally, a "emergency start button" (manual power supply control 136) can be implemented, that ramps the magnet up as fast as possible and automatically prepares or performs all necessary subsequent calibrations and preparations in order be able to scan a patient in case of emergency without delay despite the magnet being ramped down initially.

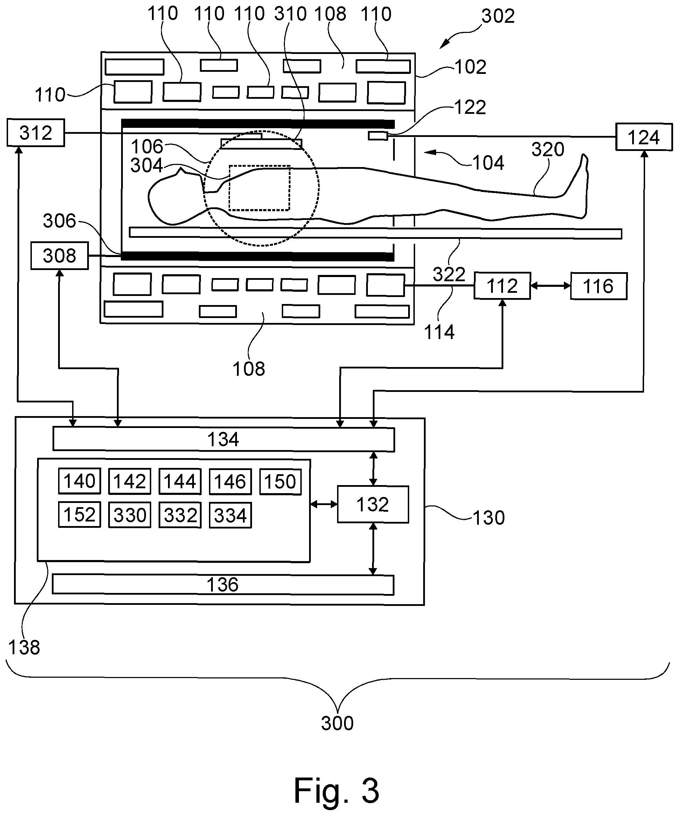

Fig. 3 illustrates a further example of the medical system 300. The medical system 300 is similar to the medical system 100 depicted in Fig. 1 except that it additionally comprises a magnetic resonance imaging system 302. The magnet 102 and the magnet power supply 112 are part of the magnetic resonance imaging system 302.

Within the imaging zone 106 there is a field of view 304 for which k-space data is acquired. Within the bore 104 of the magnet 102 there are additionally magnetic field gradient coils 306, which are used for generating a gradient magnetic field during the acquisition of k-space data. The magnetic field gradient coils 306 are connected to a magnetic field gradient power supply 308. Within the bore 104 of the magnet 102 there is additionally a radio-frequency coil 310 connected to a receiver 312.

A subject 320 is supported by a subject support 322 and is shown as being partially within the imaging zone 106. The field of view 306 is positioned over a chest region of the subject 320.

The magnet power supply 112, the magnetic field sensor controller 124, the magnetic field gradient coil power supply 308, and the transceiver 312 are shown as being connected to the hardware interface 134.

The memory 138 is shown as additionally containing the pulse sequence commands 330. The pulse sequence commands 330 are commands or data which may be converted into such commands, which are able to control the various components of the magnetic resonance imaging system 302 to acquire k-space data. The memory 138 is further shown as comprising the k-space data 332. The memory 138 is further shown as comprising a magnetic resonance image 334 that has been reconstructed from the k-space data 332.

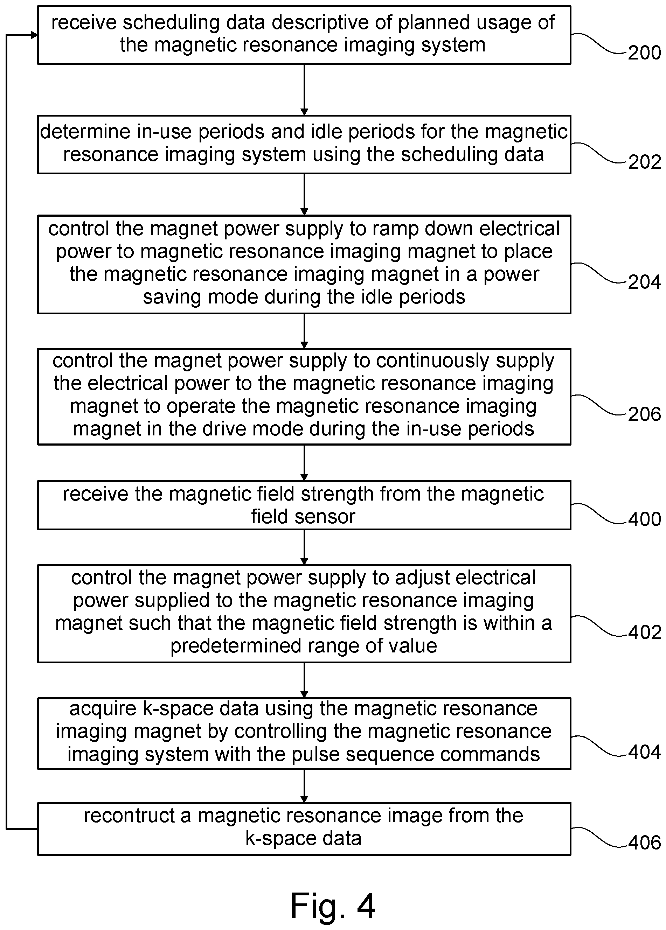

Fig. 4 is shown as containing a flowchart which illustrates a method of controlling the medical system 300. Steps 200, 202, 204, and 206 are performed as illustrated in Fig. 2. In step 400, the magnetic field strength 150 is received from the magnetic field sensor 122 and the magnetic field sensor controller 124. In step 402, the magnet power supply is controlled to adjust the electrical power supplied to the magnetic resonance imaging magnet 102 such that the magnetic field strength 150 is within a predetermined range of value 152. This has the benefit of ensuring that the magnetic field within the imaging zone 106 has the correct value and is stable. In step 404, the k-space data 332 is acquired by controlling the magnetic resonance imaging system 302 with the pulse sequence commands 330. In step 406, the magnetic resonance image 334 is reconstructed from the k-space data.

It is understood that one or more of the aforementioned examples or embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen,

Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims. In the claims, the word "comprising" does not exclude other elements or steps, and the indefinite article "a" or "an" does not exclude a plurality. A single processor or other unit may fulfill the functions of several items recited in the claims. The mere fact that certain measures are recited in mutually different dependent claims does not indicate that a combination of these measures cannot be used to advantage. A computer program may be stored/distributed on a suitable medium, such as an optical storage medium or a solid-state medium supplied together with or as part of other hardware, but may also be distributed in other forms, such as via the Internet or other wired or wireless telecommunication systems. Any reference signs in the claims should not be construed as limiting the scope.

K-space data is defined herein as being the recorded measurements of radio frequency signals emitted by atomic spins using the antenna of a Magnetic resonance apparatus during a magnetic resonance imaging scan.

A Magnetic Resonance Imaging (MRI) image or MR image is defined herein as being the reconstructed two- or three-dimensional visualization of anatomic data contained within the magnetic resonance imaging data. This visualization can be performed using a computer.

### REFERENCE SIGNS LIST

- 100: medical system
- 102: magnetic resonance imaging magnet
- 104: bore of magnet
- 106: imaging zone
- 108: cryostat
- 110: superconducting windings
- 112: magnet power supply
- 114: permanent connection
- 116: battery
- 118: emergency power supply
- 120: emergency power supply controller
- 122: magnetic field sensor
- 124: magnetic field sensor controller
- 130: computer
- 132: computational system
- 134: hardware interface
- 136: manual power supply control
- 138: memory
- 140: machine executable instructions
- 142: scheduling data
- 144: determined in-use periods
- 146: determined idle periods
- 150: measured magnetic field strength
- 152: predetermined range of value
- 200: receive scheduling data descriptive of planned usage of the magnetic resonance imaging system
- 202: determine in-use periods and idle periods for the magnetic resonance imaging system using the scheduling data
- 204: control the magnet power supply to ramp down electrical power to magnetic resonance imaging magnet to place the magnetic resonance imaging magnet in a power saving mode during the idle periods
- 206: control the magnet power supply to continuously supply the electrical power to the magnetic resonance imaging magnet to operate the magnetic resonance imaging magnet in the drive mode during the in-use periods
- 300: medical system
- 302: magnetic resonance imaging system
- 304: field of view
- 306: magnetic field gradient coils
- 308: magnetic field gradient coil power supply
- 310: radio-frequency coil
- 312: transceiver
- 320: subject
- 322: subject support
- 330: pulse sequence commands
- 332: k-space data
- 334: magnetic resonance image
- 400: receive the magnetic field strength from the magnetic field sensor
- 402: control the control the magnet power supply to adjust electrical power supplied to the magnetic resonance imaging magnet such that the magnetic field strength is within a predetermined range of value
- 404: acquire k-space data using the magnetic resonance imaging magnet by controlling the magnetic resonance imaging system with the pulse sequence commands
- 406: reconstruct a magnetic resonance image from the k-space data

## Claims

1. A medical system (100, 300) comprising:
- a magnetic resonance imaging magnet (102) for a magnetic resonance imaging system (302), wherein the magnetic resonance imaging magnet comprises superconducting windings (110);
- a magnet power supply (112) configured to provide electrical power to the superconducting windings, wherein the magnet power supply is configured to operate the magnetic resonance imaging magnet in a driven mode;
- a memory (138) storing machine executable instructions (140);
- a computational system (132), wherein execution of the machine executable instructions causes the computational system to repeatedly:
- receive (200) scheduling data descriptive (142) of planned usage of the magnetic resonance imaging system;
- determine (202) in-use periods (144) and idle (146) periods for the magnetic resonance imaging system using the scheduling data;
- control (204) the magnet power supply to ramp down electrical power to the magnetic resonance imaging magnet to place the magnetic resonance imaging magnet in a power saving mode during the idle periods; and
- control (206) the magnet power supply to continuously supply the electrical power to the magnetic resonance imaging magnet to operate the magnetic resonance imaging magnet in the drive mode during the in-use periods.

2. The medical system of claim 1, wherein the magnet power supply comprises a battery (116), wherein the magnet power supply is configured to store electrical power from the magnetic resonance imaging magnet in the battery during ramp down.

3. The medical system of claim 2, wherein the medical system further comprises an emergency power system (118), wherein the emergency power system comprises the battery.

4. The medical system of claim 3, wherein execution of the machine executable instructions further causes the computational system to:
- receive a facility alert from the emergency power system; and
- control the magnet power supply to supply to ramp down electrical power to magnetic resonance imaging magnet to supply electrical power to the battery in response to the facility alert.

5. The medical system of any one of the preceding claims, wherein the medical system further comprises a magnetic resonance imaging system (302), wherein the magnetic resonance imaging system comprises the magnetic resonance imaging magnet, wherein the memory further stores pulse sequence commands (330), wherein execution of the machine executable instructions causes the computational system to acquire (404) k-space data (332) using the magnetic resonance imaging magnet by controlling the magnetic resonance imaging system with the pulse sequence commands when the magnetic resonance imaging magnet is being operated in the drive mode.

6. The medical system of claim 5, wherein execution of the machine executable instructions further causes the computational system to control the magnet power supply to ramp down electrical power to magnetic resonance imaging magnet to place the magnetic resonance imaging magnet in the power saving mode after acquisition of the k-space data is complete.

7. The medical system of any one of the preceding claims, wherein the magnetic resonance imaging magnet comprises a magnetic field sensor (122, 124) configured for measuring a magnetic field strength (150), wherein execution of the machine executable instructions further causes the computational system to repeatedly:
- receive (400) the magnetic field strength from the magnetic field sensor;
- control (402) the magnet power supply to adjust electrical power supplied to the magnetic resonance imaging magnet such that the magnetic field strength is within a predetermined range of value (152).

8. The medical system of any one of the preceding claims, wherein the step of receiving scheduling data comprises any one of the following:
- fixed operating times for the magnetic resonance imaging magnet;
- appointments for magnetic resonance imaging examinations using the magnetic resonance imaging system; and
- combinations thereof.

9. The medical system of any one of the preceding claims, wherein the medical system comprises a manual power supply control (136) configured to manually override control of the magnet power supply to ramp down electrical power to magnetic resonance imaging magnet or to continuously supply the electrical power to the magnetic resonance imaging magnet to operate the magnetic resonance imaging magnet in the drive mode.

10. The medical system of any one of the preceding claims, wherein any one of the following:
- during the idle period the electrical power supplied to the magnetic resonance imaging magnet is reduced to zero; and
- during the idle period electrical power supplied to the magnetic resonance imaging magnet is reduced by 80% to 50% compared to when the magnetic resonance imaging magnet in the driven mode.

11. The medical system of any one of the preceding claims, wherein the super conducting windings are formed from any one of the following: MgB2, YBCO, ReBCO, BSCCO, and BSCCO2212.

12. The medical system of any one of the preceding claims, wherein the magnet power supply is permanently connected (114) to the superconducting windings.

13. A method of operating a medical system, the medical system comprising:
- a magnetic resonance imaging magnet for a magnetic resonance imaging system, wherein the magnetic resonance imaging magnet comprises superconducting windings; and
- a magnet power supply configured to provide electrical power to the superconducting windings, wherein the magnet power supply is configured to operate the magnetic resonance imaging magnet in a driven mode;
wherein the method comprises repeatedly:
- receiving (200) scheduling data descriptive of planned usage of the magnetic resonance imaging system;
- determining (202) in-use periods and idle periods for the magnetic resonance imaging system using the scheduling data;
- controlling (204) the magnet power supply to ramp down electrical power to the magnetic resonance imaging magnet to place the magnetic resonance imaging magnet in a power saving mode during the idle periods; and
- controlling (206) the magnet power supply to continuously supply the electrical power to the magnetic resonance imaging magnet to operate the magnetic resonance imaging magnet in the drive mode during the in-use periods.

14. A computer program comprising machine executable instructions (140) for execution by a computational system (132) configured for controlling a medical system (100, 300), the medical system comprising:
- a magnetic resonance imaging magnet (102) for a magnetic resonance imaging system (302), wherein the magnetic resonance imaging magnet comprises superconducting windings (110);
- a magnet power supply (112) configured to provide electrical power to the superconducting windings, wherein the magnet power supply is configured to operate the magnetic resonance imaging magnet in a driven mode;
wherein execution of the machine executable instructions causes the computational system to repeatedly:
- receive (200) scheduling data (142) descriptive of planned usage of the magnetic resonance imaging system;
- determine (202) in-use periods (144) and idle periods (146) for the magnetic resonance imaging system using the scheduling data;
- control (204) the magnet power supply to ramp down electrical power to the magnetic resonance imaging magnet to place the magnetic resonance imaging magnet in a power saving mode during the idle periods; and
- control (206) the magnet power supply to continuously supply the electrical power to the magnetic resonance imaging magnet to operate the magnetic resonance imaging magnet in the drive mode during the in-use periods.
